# EUROPEAN PATENT SPECIFICATION

(11) **EP 0 273 961 B1**
(45) Date of publication and mention of the grant of the patent: **02.03.1994**
(21) Application number: 87904620.9
(22) Date of filing: 01.07.1987
(51) Int. Cl.: G05F 7/00, H03K 17/64, H03K 17/66

(54) **METHOD AND APPARATUS FOR CONTROLLING THE AMOUNT OF MAGNETIC FLUX IMPARTED TO A FERRIMAGNETIC LOAD**
VERFAHREN UND APPARAT ZUR STEUERUNG DES BETRAGS DES MAGNETISCHEN FLUSSES EINER FERROMAGNETISCHEN LAST
PROCEDE ET APPAREIL PERMETTANT DE REGULER LA QUANTITE DE FLUX MAGNETIQUE APPLIQUE A UNE CHARGE FERROMAGNETIQUE

(30) Priority: 01.07.1986 US 880765
(43) Date of publication of application: 13.07.1988
(73) Proprietor: Hughes Aircraft Company, Los Angeles, California 90045-0066 (US)
(72) Inventor: MYERS, Terrence, L., Fullerton, CA 92633 (US); HARRINGTON, William, A., Whittier, CA 90602 (US)
(74) Representative: KUHNEN, WACKER & PARTNER
(86) International application number: US8701591
(87) International publication number: WO8800370

(56) References cited:
- US-A- 3 510 675
- US-A- 3 521 079
- US-A- 3 626 425

## Description

The present invention relates to an apparatus for controlling the amount of energy imparted to a ferrimagnetic material according to the preamble of claim 1, and deals more particularly with a device-implemented method for driving a phase shifter for an antenna array in which the magnetic flux imparted to the phase shifter is precisely metered.

Phase shifters are used as primary components in electronically controlled array antennas. An array antenna contains many individual radiating elements. By properly controlling the phase of each element, the resulting beam of the antenna can be steered electronically. By using a so-called reciprocal phase shifter, the same antenna can be used as a receiving antenna with a steerable beam.

Ferrite phase shifters employed in array antennas are formed by placing ferrite materials in a section of a waveguide. The ferrite phase shifter can be either a reciprocal or non-reciprocal device depending upon its configuration. In a reciprocal phase shifter, phase shifting is accomplished by changing the magnetic permeability of the ferrite through changing the externally applied DC magnetic field. Non-reciprocal ferrite phase shifters provide a shift in microwave phase dependent upon the amount of remanent magnetism in the ferrimagnetic element. A coil of wire, forming an inductive load, is normally used to alter the strength of the magnetic field in a reciprocal phase shifter. The strength of the field In a non-reciprocal phase shifter is a function of voltage across its toroidal winding versus the period of time during which the voltage is applied.

In the past, the strength of the magnetic field was controlled by controlling the time period for which the voltage was applied to the coil. In order to accomplish this, the switching speeds of the control element were required to be extremely fast and it was also necessary that the applied voltage be controlled very precisely. In US-A-3,947,776 and in US-A-4,469,961, there are disclosed methods for driving inductive loads, such as phase shifters, which rely on extremely fast switching times. Specifically, the arrangements in these patents relate to reciprocal-type phase shifters for establishing and then sustaining a current flow by reducing the drive voltage. These previous systems were less than completely satisfactory in terms of their speed and accuracy because of variables which affect the switching time, such as variations in rise time, voltage drops on the power supply and temperature variations.

According to a first aspect of the present invention, it is suggested to overcome the above mentioned deficiencies by providing an apparatus which controls the amount of magnetic energy imparted to the ferrimagnetic material, i.e. the ferrite phase shifter. An apparatus of that type is already known from US-A-3,626,425, which discloses all features mentioned in the preamble of claim 1. Hence, this document discloses an apparatus wherein a source of electrical power is applied to a load which generates magnetic energy and which applies this magnetic energy to the ferrimagnetic material. This known apparatus further controls the source of electrical power and comprises a sensing means for sensing the voltage across the load and for producing an output signal which is proportional to the sensed voltage, an integration means which is responsive to this sensing means for integrating the output signal as a function of time and for producing a time integrated signal, a reference signal generator for generating a reference signal which is proportional to a preselected amount of magnetic energy which is to be imparted to the ferrimagnetic material, a comparison means for comparing the time integrated signal with the reference signal, and a control means which is responsive to the comparison means for controlling the application of electrical power to the load. In US-A-3,510,675, there is also disclosed a control apparatus of that type which allows to linearize the flux within a ferrimagnetic material.

Although the application of a control appartus of the a.m. type to the ferrite phase shifter of an antenna array allows to efficiently control the strength of the magnetic field thereof, a drawback of the known apparatus, however, has to be seen in that a destruction of the load (i.e. the phase shifter) cannot be excluded under all circumstances.

It is therefore the object of the present invention to improve a control apparatus according to the preamble of claim 1 in such a way that the load cannot be destroyed.

According to the present invention this object is solved by the advantageous measures indicated in the characterizing part of claim 1.

Hence, according to the present invention, it is proposed to provide second sensing means for sensing the current which flows through the load (the phase shifter); by furthermore making the control means of the apparatus responsive to this sensing means in such a way that the application of electrical power to the load device can be controlled, it is possible to suppress any detrimental effect which is due to an overcurrent; the load (phase shifter), therefore, cannot be destroyed.

Advantageous further developments of the present invention are indicated in the subclaims.

The invention now will be described in more detail with reference to the accompanying drawings, in which:
Figures 1 and 2, taken together, form a detailed schematic diagram of a circuit for driving a ferrimagnetic load, which forms the preferred embodiment of the present invention; and
Figure 3 is a plan view showing how Figures 1 and 2 are to be arranged for proper viewing.

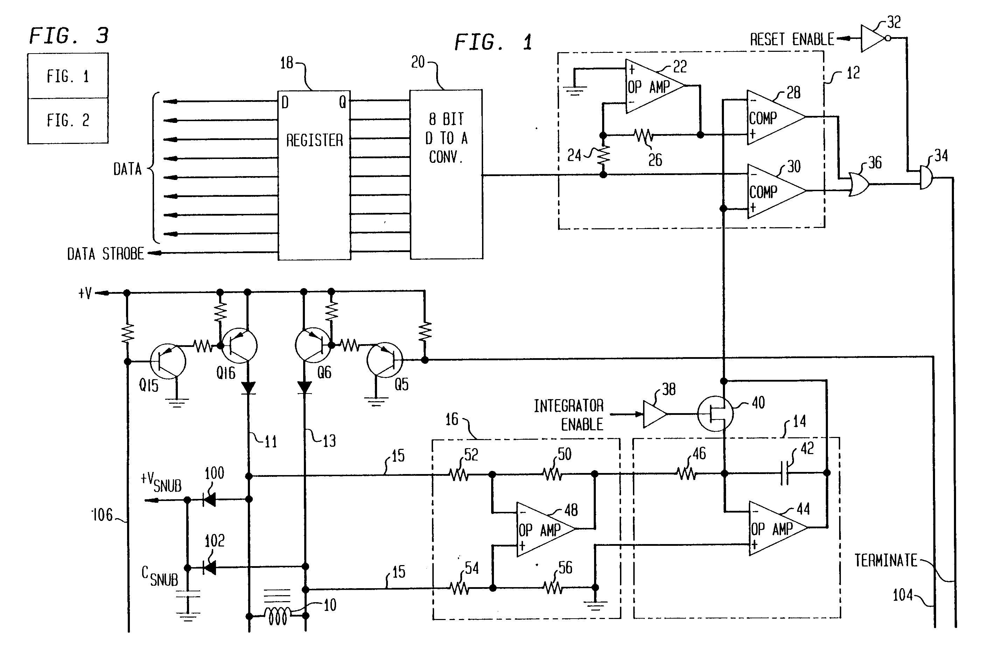

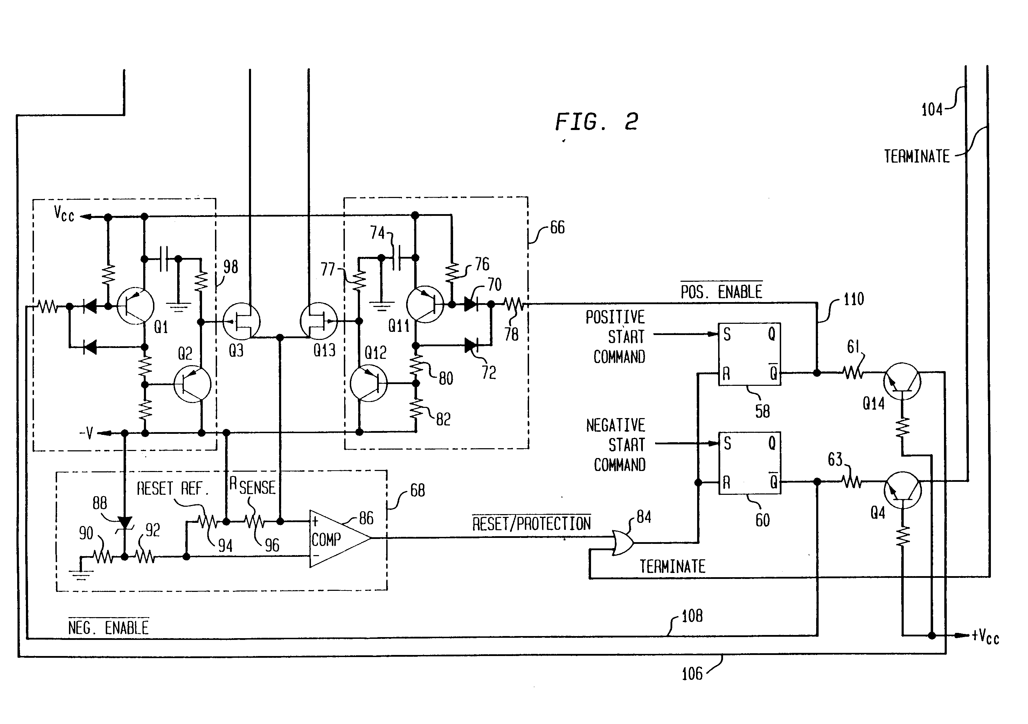

Referring to Figures 1 and 2, the present invention broadly relates to an apparatus for driving an inductive load and particularly a ferrimagnetic load, such as the coil 10 of a nonreciprocal type ferrite phase shifter. The phase shifter is used in a radar or communiations system, and more particularly an antenna array, comprising a plurality of individual radiating elements. The phase shift imparted to each radiating element is dependent upon the quantity of gauss contained in the magnetic field of the phase shifter. The strength of the field in the ferrite is a function of the voltage across the coil 10 and the period of time that this voltage is applied.

The coil 10 is coupled across a pair of lines 11, 13 and is "driven" by a pair of bridged drivers comprising transistors Q5, Q6, Q15 and Q16. These drivers are referred to as being "bridged" because the coil 10 is connected between the two sets of drivers, i.e. one side of coil 10 is connected via line 13 to drivers Q5, Q6 while the other side of the coil 10 is connected via line 11 to transistors Q15, Q16. These drivers respectively deliver current alternately through the coil 10 in opposite directions. Transistor Q5 has its base connected with a control line 104 and is operative to control the base electrode of transistor Q6. The collector-to-emitter path of the transistors Q6 and Q16 are connected between a positive source of voltage and the coil 10. Transistor Q15 has its base connected to a control line 106 and is operative to control the base electrode of transistor Q16.

Transistors Q15 and Q16 cooperate with a switching transistor Q3 and a Baker-clamped driver generally indicated within the broken line 98. The Baker-clamped driver 98 broadly includes a pair of transistors Q1 and Q2 which control the gate of transistor Q3, and is controlled by a negative enable signal received on line 108.

Similarly, transistors Q5 and Q6 operate in concert with a switching transistor Q13 and a Baker-clamped driver, generally indicated within the broken line 66. The Baker-clamped driver 66 includes a pair of transistors Q11, Q12 as well as resistors 76, 77, 78, 80 and 82, capacitors 74 and diodes 70, 72. The Baker clamp driver 66 is essentially identical in all respects to driver 98 and is controlled by a positive enable signal received on line 110. The driver 66 is connected to and controls the gate of transistor Q13. Transistors Q3 and Q13 are MOSFET's which by their nature have a particularly fast switching time. The source-to-drain path of each of the transistors Q3, Q13 are connected with each other and with a current sensing circuit 68 which functions to sense the magnitude of current flowing through the coil 10. The current sensing circuit 68 includes an operational amplifier 86, a zener diode 88 and resistors 92, 96. Resistor 90 completes the current path for diode 88. The op-amp 86 is configured as a comparator so as to compare the voltage on its non-inverting input, which is proportional to the flow of current through coil 10, with a reference voltage on its inverting input. The output of the comparator 86 is delivered through an OR gate 84 to the reset inputs of a pair of flip-flops 58,60. The set inputs of flip-flops 58 and 60 are connected with the incorporating communications system (not shown) which controls the antenna in its transmit and receive modes. The Q̅ output of flip-flop 58 is delivered on line 110 as a positive enabling signal to the Baker clamp driver 66, and is also delivered through resistor 61 and through transistor Q14 as an enabling signal to the base of transistor Q15, on line 106. In Q̅ a similar manner, the Q̅ output of flip-flop 60 is delivered as a negative enabling signal on line 108 to the Baker-clamped driver 98, and is also delivered through resistor 63 and through transistor Q4 and line 104 to the base of transistor Q5.

Means generally indicated within the broken line 16 are provided for sensing the magnitude of voltage applied across the coil 10. The voltage sensing means 16 is connected across the coil 10 by means of lines 15. The voltage sensing means 16 comprises an op-amp 48 and resistors 50, 52, 54, 56. The output of the voltage sensor 16 is delivered to an integrator 14 which functions to integrate the sensed voltage over time. The integrator 14 comprises an operational amplifier 44, a resistor 46 and a capacitor 42 connected in feedback between the output of the op-amp 44 and its inverting input. The integrator 14 is controlled by a switch in the nature of a FET 40 which receives an enabling signal from the incorporating communications system through an amplifier 38.

The time integrated voltage value output by the integrator 14 is delivered to the inverting and non-inverting inputs respectively of a pair of comparators 28 and 30. Op-amp 22 and resistors 24, 26 invert the voltage applied to the non-inverting input of comparator 28. Comparators 28, 30, along with an op-amp 22 and resistors 24 and 26, form a "window comparator" which functions to compare or "threshold" the time integrated voltage value provided by the integrator 14 with a reference value when the coil 10 is being set either in a transmit or receive mode. This reference value is defined by a multibit digital data word which is received from a suitable source such as a memory (not shown). In the present example, the data word comprises eight bits which are loaded from the source (memory) into a register 18 upon receipt at the register 18 of a data strobe signal from the incorporating communication system. A D/A converter 20 converts the digital data to an analog signal which is delivered to the non-inverting and inverting inputs respectively of the comparators 28,30. In regard to the input to comparator 28, the voltage is inverted as dIscussed above. The outputs of the comparators 28,30 are delivered through an OR gate 36 to one input of an AND gate 34. The second input to the AND gate 34 is formed by a reset enable signal received from the incorporating communications system which is inverted by an inverter 32. The output of the AND gate 34 is delivered through the other input of OR gate 84 to the reset inputs of flip-flops 58, 60.

Having generally described the components of the circuit, a more detailed description will now be given with reference to its operation. In connection with the present description, it will be assumed that the phase shifter of which the coil 10 forms a part is of the non-reciprocal type in which the phase shift applied to an incoming or received signal is different from that applied to an outgoing, transmitted signal. It is thus necessary to "set" the ferrite with the appropriate amount of magnetic flux very quickly between the transmit and receive cycles. The data word loaded into the register 18 is preprogrammed and may be, for example, non-linear. This data word corresponds to a voltage value to be integrated across the coil 10 during the transmit and receive cycles. This value may be the same for both the transmit and receive cylces but of opposite polarity. In other words, the value represented by this data word is proportional to the magnitude of magnetic flux imparted to the ferrite by the coil 10.

Initially, before a metered amount of flux is imparted to the ferrite from the coil 10, the coil 10 is reset by driving it into saturation. By driving the coil 10 into saturation, the initial value of the magnetic flux is known and this flux remains in the ferrite after the current is turned off. The reset cycle will be described later in more detail. Assume now that the ferrite has been reset and it is desired to set the ferrite in preparation for a transmit cycle. Digital data is delivered from a central bus of the incorporating communications system and is latched into the register 18. As mentioned above, the data word stored in register 18 corresponds to the voltage to be integrated across the coil 10 and is thus proportional to the amount of phase shift to be set in the ferrite. The D/A converter 20 converts the digital data to an analog, DC voltage signal which is delivered to the input of the window comparator 12. The op-amp 22 provides its complements to the comparators 28, 30 which form an absolute value peak detector. At this point, the integrator enabling signal from the incorporating communications system controls the FET switch 40 so as to discharge the capacitor 42 until the output of the integrator 14 is zero. A positive start command signal received at the set input of flip-flop 58 causes the Q̅ output to drive the common base buffer transistor Q14 and the Baker-clamped driver 66. The enabling signal, delivered from transistor Q14 through line 106 to transistor Q15, turns on the latter. With transistor Q15 on, its emitter-follower drives the power transistor Q16 which forms one-half of the positive side of the bridge. The Baker-clamped driver 66 provides a voltage at the base of transistor Q12 which is sufficient to drive the power MOSFET Q13 which forms one part of the other side of the bridge. A circuit is thus completed which connects the coil 10 across the power supply, +V, -V, which can be traced as follows: from +V through transistor Q16, coil 10, MOSFET Q13 and transistor Q12 to -V. The voltages denoted by +V and -V are selected in accordance with switching time requirements of the application. +Vcc is a voltage appropriate to the logic devices employed.

The voltage sensor 16 outputs a voltage which is the absolute sum of the voltage on lines 11 and 13 referenced to ground. This absolute voltage is delivered to the integrator 14 which commences charging the capacitor 42. The integrator 14 supplies an output signal to the window comparator 12 which is a voltage/time product, i.e. the voltage applied across the coil 10 as a function of time. The comparator 12 compares the voltage time product supplied by the integrator 14 with the DC signal supplied by the D/A converter 20. When the voltage time product exceeds the value of the DC voltage signal supplied by the D/A converter 20, a signal is delivered through one of the comparators 28, 30 and OR gate 36 to one input of AND gate 34. At this point, the second input to AND gate 34 consisting of the reset enable signal is high, consequently a high signal is output from the AND gate 34 which functions to reset the flip-flop 58 through OR gate 84 connected by the line labled TERMINATE. The enabling signal output from the flip-flop 58 is removed, thereby turning off the bridge. During this turn-off phase, the positive side of the bridge turns off slowly but the output of the Baker-clamped driver 66 drops quickly. The emitter follower of transistor Q12 removes the stored charge on the gate of the MOSFET 13 causing the latter to turn off quickly to leave a precisely metered amount of flux in the ferrite core of the phase shifter. Variables such as rise time, voltage variations in the power supply and temperature variations are taken into consideration by the voltage sensor 16 and the integrator 14. In the invention, the voltage across the coil 10 is not required to be constant over time as in prior techniques but an integration of voltage over time is used. Therefore, the amount of flux applied to the ferrimagnetic load by the coil is independent of the above-mentioned variations. The back EMF spike produced across the coil 10 is dissipated into a snubbing capacitor C_{snub} via diodes 100, 102. The accumulated charge on C_{snub} is removed by an external shunt regulator, V_{snub}.

During the reset mode, a high reset enable signal is inverted to a low signal by inverter 32, thereby disabling the output of AND gate 34. With AND gate 34 disabled, the window comparator 12 is likewise disabled, thus the flip-flops 58, 60 cannot be reset by the output of AND gate 34. In the reset mode, a start signal is delivered to the set input of one of the flip-flops 58, 60. For example, if a start signal is delivered to the set input of flip-flop 58, the positive side of the bridge will be turned on resulting in current flow in one direction through the coil 10. The current through the coil 10 increases until the voltage across resistor 96 (Rₛₑₙₛₑ ) exceeds a reset reference voltage on the inverting input of comparator 86. When this latter-mentioned reset reference voltage is exceeded, a signal is delivered from the output of comparator 86 through OR gate 84 to the reset input of flip-flop 58, the reset reference voltage on the inverting input of comparator 86 is such as to assure chat the current through coil 10 during the reset cycle is sufficient to saturate the ferrite. This voltage is determined by resistors 92 and 94 which provide a voltage divider. It should be noted here that the current sensor 68 functions as a protective circuit to limit the magnitude of current flowing through the coil 10, even during the set cycle with the window comparator 12 enabled.

In order to set the ferrite in preparation for a receive mode, the start signal is delivered to the set input of flip-flop 60, rather than flip-flop 58. In response to a negative start signal, an output signal is delivered on line 108 to the Baker-clamped driver 98, and through the buffering transistor Q4 to the base of transistor Q5. Transistor Q5 drives transistor Q6 so that current flows from -V through transistors Q2, Q3, the coil 10 and transistor Q6 to +V.

## Claims

1. An apparatus for controlling the amount of magnetic energy imparted to a ferrimagnetic material, wherein a source of electrical power is applied to a load (10) which generates magnetic energy and which applies said magnetic energy to said ferrimagnetic material, said apparatus further controlling said source of electrical power and comprising:
**[a]** first sensing means (16) for sensing the voltage across said load (10) and for producing an output signal being proportional to the sensed voltage;
**[b]** integration means (14) being responsive to said first sensing means (16) for integrating said output signal as a function of time and for producing a time integrated signal;
**[c]** a reference signal generator (18, 20) for generating a reference signal which is proportional to a preselected amount of magnetic energy to be imparted to said ferrimagnetic material;
**[d]** comparison means (12) for comparing said time integrated signal with said reference signal;
**[e]** and control means (58, 60) being responsive to said comparison means (12) for controlling the application of electrical power to said load (10);
***characterized by***
**[f]** second sensing means (68) for sensing the current flowing through said load (10);
**[g]** wherein said control means (58,60) is also responsive to said second sensing means (68) for controlling the application of electrical power to said load (10).

2. An apparatus according to claim 1, ***characterized in*** that said second sensing means (68) delivers a disabling control signal to said control means (58, 60) when the sensed current exceeds a preselected value, wherein said control means (58, 60) terminates the current flowing to said load (10) in response to said disabling control signal.

3. An apparatus according to claim 1 or 2, ***characterized in*** that the output of said comparison means (12) and the output of said second sensing means (68) are connected to the input of said control means (58, 60) via an OR Gatte (84).

4. An apparatus according to one of claims 1 through 3, ***characterized in*** that said integration means includes capacitive means (42) for accumulating a charge which is proportional to the time during that the output signal is applied thereto.

5. An apparatus according to one of claims 1 through 4, ***characterized in*** that said reference signal generator (18, 20) receives a multibit digital reference word being representative of said preselected amount of magnetic energy, and includes storage means (18) for storing said digital reference word and converting means (20) for converting said multibit digital data reference word into an analog reference signal which is applied to said comparison means (12).

6. An apparatus according to one of claims 1 through 5, ***characterized in*** that said sensing means (16) includes a difference amplifier (48) for measuring the difference in voltage of each side of said load (10) with respect to a preselected value, said output signal being defined by said voltage difference.

7. An apparatus according to one of claims 1 through 6, ***characterized in*** that said comparison means (12) compares said time integrated signal with said reference signal and produces a disabling signal when the value of said time integrated signal reaches the value of said reference signal, said control means (58, 60) being responsive to said disabling signal for controlling the application of the electrical power source to the load (10).

8. An apparatus according to one of claims 1 through 7, ***characterized in*** that said apparatus further comprises switch means (Q6, Q16) for selectively coupling said load (10) with said power source in either of two polarities such that current flows through said load (10) in either of two opposite directions as switched.

9. An apparatus according to claim 8, ***characterized in*** that:
**[a]** said switch means (Q6, Q16) couples said source of electrical power to said load (10) in one polarity such that electrical current may be conducted through said load (10) in the corresponding first direction until said ferrimagnetic material is substantially saturated;
**[b]** said switch means (Q6, Q16) couples said source of electrical power to said load (10) in the second polarity such that electrical current may be conducted through said load (10) in the corresponding second direction;
**[c]** said sensing means (16) senses the value of voltage across said load (10) while current is being conducted in said second direction and produces said output signal in response thereto;
**[d]** said integration means integrates said output signal over time, said time integrated signal being proportional to the amount of magnetic flux imparted to said ferrimagnetic material;
**[e]** said comparison means (12) compares the time integrated signal with said reference signal, wherein in the event that the time integrated signal reaches the value of said reference signal, said comparison means (12) produces a disabling signal; and
**[f]** said control means (58, 60) is responsive to said disabling signal to terminate the conduction of electrical current in said second direction.

## Patentansprüche

1. Gerät zum Steuern der Menge der auf ein ferrimagnetisches Material übertragenen magnetischen Energie, bei dem eine elektrische Stromversorgungsquelle an eine Last (10) angelegt wird, die magnetische Energie erzeugt und die magnetische Energie an das ferrimagnetische Material anlegt, wobei das Gerät ferner die elektrische Stromversorgungsquelle steuert und aufweist:
**[a]** eine erste Fühleinrichtung (16) zum Erfassen der an der Last (10) anliegenden Spannung und zum Erzeugen eines zu der erfaßten Spannung proportionalen Ausgangssignals;
**[b]** eine auf die erste Fühleinrichtung (16) ansprechende Integriereinrichtung (14) zum Integrieren des Ausgangssignals als eine Funktion der Zeit und zum Erzeugen eines zeitintegrierten Signals;
**[c]** einen Referenzsignal-Generator (18,20) zum Erzeugen eines Referenzsignals, das proportional zu einer vorgewählten Menge der auf das ferrimagnetische Material zu übertragenden magnetischen Energie ist;
**[d]** eine Vergleichseinrichtung (12) zum Vergleichen des zeitintegrierten Signals mit dem Referenzsignal;
**[e]** und eine auf die Vergleichseinrichtung (12) ansprechende Steuereinrichtung (58, 60) zum Steuern der Zufuhr von elektrischer Leistung zur Last (10);
*gekennzeichnet durch*
**[f]** eine zweite Fühleinrichtung (68) zum Erfassen des durch die Last (10) fließenden Stroms;
**[g]** wobei die Steuereinrichtung (58,60) auf die zweite Fühleinrichtung (68) ebenfalls anspricht, um die Zufuhr der elektrischen Leistung zur Last (10) zu steuern.

2. Gerät nach Anspruch 1, *dadurch gekennzeichnet, daß* die zweite Fühleinrichtung (68) der Steuereinrichtung (58,60) ein sperrendes Steuersignal zuführt, wenn der erfaßte Strom einen vorgewählten Wert übersteigt, wobei die Steuereinrichtung (58,60) den zur Last (10) fließenden Strom im Ansprechen auf das sperrende Steuersignal unterbricht.

3. Gerät nach Anspruch 1 oder 2, *dadurch gekennzeichnet, daß* der Ausgang der Vergleichseinrichtung (12) und der Ausgang der zweiten Fühleinrichtung (68) über ein ODER-Gatter (84) mit dem Eingang der Steuereinrichtung (58, 60) verbunden sind.

4. Gerät nach einem der Ansprüche 1 bis 3, *dadurch gekennzeichnet, daß* die Integriereinrichtung eine kapazitive Einrichtung (42) zum Akkumulieren einer Ladung aufweist, die proportional zu derjenigen Zeit ist, während der das Ausgangssignal an ihr anliegt.

5. Gerät nach einem der Ansprüche 1 bis 4, *dadurch gekennzeichnet, daß* der Referenzsignal-Generator (18,20) ein digitales Multibit-Referenzwort empfängt, das die vorgewählte Menge der magnetischen Energie repräsentiert, und eine Speichereinrichtung (18) zum Speichern des digitalen Referenzworts sowie eine Umsetzeinrichtung (20) zum Umsetzen des Multibit-Digitaldaten-Referenzworts in ein analoges Referenzsignal aufweist, das der Vergleichseinrichtung (12) zugeführt wird.

6. Gerät nach einem der Ansprüche 1 bis 5, *dadurch gekennzeichnet, daß* die Fühleinrichtung (16) einen Differenzverstärker (48) zum Messen der Differenz in der Spannung jeder Seite der Last (10) bezüglich eines vorgewählten Werts aufweist, wobei das Ausgangssignal durch die Spannungsdifferenz definiert ist.

7. Gerät nach einem der Ansprüche 1 bis 6, *dadurch gekennzeichnet, daß* die Vergleichseinrichtung (12) das zeitintegrierte Signal mit dem Referenzsignal vergleicht und ein Sperrsignal erzeugt, wenn der Wert des zeitintegrierten Signals den Wert des Referenzsignals erreicht, wobei die Steuereinrichtung (58,60) auf das Sperrsignal anspricht, um das Anlegen der elektrischen Stromversorgungsquelle an die Last (10) zu steuern.

8. Gerät nach einem der Ansprüche 1 bis 8, *dadurch gekennzeichnet, daß* das Gerät weiterhin eine Schalteinrichtung (Q6, Q16) zum selektiven Verbinden der Last (10) mit der Stromversorgungsquelle in jeder von zwei Polaritäten in der Weise aufweist, daß der Strom je nach Schaltung in einer von zwei entgegengesetzten Richtungen durch die Last (10) fließt.

9. Gerät nach Anspruch 8, *dadurch gekennzeichnet, daß*:
**[a]** die Schalteinrichtung (Q6,Q16) die elektrische Stromversorgungsquelle in einer Polarität mit der Last (10) derart verbindet, daß der elektrische Strom in der entsprechenden ersten Richtung durch die Last (10) geleitet werden kann, bis das ferrimagnetische Material im wesentlichen gesättigt ist;
**[b]** die Schalteinrichtung (Q6,Q16) die elektrische Stromversorgungsquelle in der zweiten Polarität mit der Last (10) derart verbindet, daß der elektrische Strom in der entsprechenden zweiten Richtung durch die Last (10) geleitet werden kann;
**[c]** die Fühleinrichtung (16) den Wert der über der Last (10) anliegenden Spannung erfaßt, während der Strom in der zweiten Richtung fließt, und im Ansprechen hierauf das Ausgangssignal erzeugt;
**[d]** die Integriereinrichtung das Ausgangssignal über der Zeit integriert, wobei das zeitintegrierte Signal proportional zur Menge des auf das ferrimagnetische Material übertragenen magnetischen Flusses ist;
**[e]** die Vergleichseinrichtung (12) das zeitintegrierte Signal mit dem Referenzsignal vergleicht, wobei die Vergleichseinrichtung (12) ein Sperrsignal in dem Augenblick erzeugt, in dem das zeitintegrierte Signal den Wert des Referenzsignals erreicht; und
**[f]** die Steuereinrichtung (58, 60) auf das Sperrsignal anspricht, um das Fließen des elektrischen Stroms in der zweiten Richtung zu beenden.

## Revendications

1. Appareil pour régler la quantité d'énergie magnétique communiquée à une matière ferrimagnétique, dans lequel une source d'énergie électrique est appliquée à une charge (10) qui génère une énergie magnétique et qui applique ladite énergie magnétique à ladite matière ferrimagnétique, ledit appareil commandant en outre ladite source d'énergie électrique et comportant :
[a] un premier moyen capteur (16) destiné à capter la tension aux bornes de ladite charge (10) et à produire un signal de sortie proportionnel à la tension captée ;
[b] un moyen d'intégration (14) qui, en réponse auxdits premiers moyens capteurs (16), est destiné à intégrer ledit signal de sortie en fonction du temps et à produire un signal intégré par rapport au temps ;
[c] un générateur (18, 20) de signal de référence destiné à générer un signal de référence qui est proportionnel à une quantité préalablement choisie d'énergie magnétique devant être communiquée à ladite matière ferrimagnétique ;
[d] un moyen de comparaison (12) destiné à comparer ledit signal intégré par rapport au temps audit signal de référence ;
[e] et un moyen de commande (58, 60) qui, en réponse audit moyen (12) de comparaison, est destiné à commander l'application d'énergie électrique à ladite charge (10) ;
caractérisé par
[f] un second moyen capteur (68) destiné à capter le courant circulant dans ladite charge (10) ;
[g] dans lequel ledit moyen de commande (58, 60) réagit aussi audit second moyen capteur (68) en commandant l'application d'énergie électrique à ladite charge (10).

2. Appareil selon la revendication 1, caractérisé en ce que ledit second moyen capteur (68) délivre un signal de commande d'invalidation audit moyen de commande (58, 60) lorsque le courant capté dépasse une valeur préalablement choisie, dans lequel ledit moyen de commande (58, 60) fait cesser le courant circulant vers ladite charge (10) en réponse audit signal de commande d'invalidation.

3. Appareil selon la revendication 1 ou 2, caractérisé en ce que la sortie dudit moyen (12) de comparaison et la sortie dudit second moyen capteur (68) sont connectées à l'entrée dudit moyen de commande (58, 60) par l'intermédiaire d'une porte OU (84).

4. Appareil selon l'une des revendications 1 à 3, caractérisé en ce que ledit moyen d'intégration comprend un moyen capacitif (42) destiné à accumuler une charge qui est proportionnelle au temps pendant lequel le signal de sortie lui est appliqué.

5. Appareil selon l'une des revendications 1 à 4, caractérisé en ce que ledit générateur (18, 20) de signal de référence reçoit un mot de référence numérique à bits multiples représentatif de ladite quantité préalablement choisie d'énergie magnétique, et comprend un moyen de stockage (18) destiné à stocker ledit mot de référence numérique et un moyen de conversion (20) destiné à convertir ledit mot de référence de données numériques à bits multiples en un signal de référence analogique qui est appliqué audit moyen de comparaison (12).

6. Appareil selon l'une des revendications 1 à 5, caractérisé en ce que ledit moyen capteur (16) comprend un amplificateur (48) de différence destiné à mesurer la différence de tension de chaque côté de ladite charge (10) par rapport à une valeur préalablement choisie, ledit signal de sortie étant défini par ladite différence de tension.

7. Appareil selon l'une des revendications 1 à 6, caractérisé en ce que ledit moyen (12) de comparaison compare ledit signal intégré par rapport au temps audit signal de référence et produit un signal d'invalidation lorsque la valeur dudit signal intégrée par rapport au temps atteint la valeur dudit signal de référence, ledit moyen de commande (58, 60) réagissant audit signal d'invalidation en commandant l'application de la source d'énergie électrique à la charge (10).

8. Appareil selon l'une des revendications 1 à 7, caractérisé en ce que ledit appareil comporte en outre des moyens de commutation (Q6, Q16) destinés à coupler sélectivement ladite charge (10) à ladite source d'énergie dans chacune de deux polarités telles que le courant circule à travers ladite charge (10) dans chacun de deux sens opposés sous l'effet d'une commutation.

9. Appareil selon la revendication 8, caractérisé en ce que :
[a] lesdits moyens de commutation (Q6, Q16) couplent ladite source d'énergie électrique à ladite charge (10) en une polarité telle qu'un courant électrique puisse être conduit à travers ladite charge (10) dans le premier sens correspondant jusqu'à ce que ladite matière ferrimagnétique soit sensiblement saturée ;
[b] lesdits moyens de commutation (Q6, Q16) couplent ladite source d'énergie électrique à ladite charge (10) dans la seconde polarité telle qu'un courant électrique puisse être conduit à travers ladite charge (10) dans le second sens correspondant ;
[c] ledit moyen capteur (16) capte la valeur de tension aux bornes de ladite charge (10) tandis qu'un courant est conduit dans ledit second sens et produit ledit signal de sortie en réponse à cette valeur ;
[d] ledit moyen d'intégration intègre ledit signal de sortie par rapport au temps, ledit signal intégré par rapport au temps étant proportionnel à la quantité de flux magnétique communiqué à ladite matière ferrimagnétique ;
[e] ledit moyen (12) de comparaison compare le signal intégré par rapport au temps audit signal de référence, ledit moyen de comparaison (12) produisant un signal d'invalidation dans le cas où le signal intégré par rapport au temps atteint la valeur dudit signal de référence ; et
[f] ledit moyen de commande (58, 60) réagit audit signal d'invalidation en arrêtant la conduction du courant électrique dans ledit second sens.
